# EUROPÄISCHE PATENTANMELDUNG

(11) **EP 1 213 617 A1**
(43) Veröffentlichungstag der Anmeldung: **12.06.2002**
(21) Anmeldenummer: 01128887.5
(22) Anmeldetag: 05.12.2001
(51) Int. Cl.: G03F 7/20

(54) **Verfahren und Vorrichtung zur In-situ-Dekontamination eines EUV-Lithographiegerätes**

(30) Priorität: 09.12.2000 DE 10061248
(71) Anmelder: Carl Zeiss, 73447 Oberkochen (DE); Carl-Zeiss-Stiftung trading as Carl Zeiss, 73447 Oberkochen (DE)
(72) Erfinder: Hamm, Uwe W., 89129 Langenau (DE)
(74) Vertreter: Fuchs Mehler Weiss & Fritzsche

(57) **Zusammenfassung**

EUV-Lithographiegeräte weisen zwar in ihrem Inneren ein Vakuum oder eine Inertgasatmosphäre auf, es läßt sich aber nicht völlig verhindern, daß sich auch Kohlenwasserstoffe und/oder sonstige Kohlenstoffverbindungen innerhalb des Gerätes befinden. Diese Kohlenstoffverbindungen führen zur Kontamination der optischen Elemente, die dadurch an Reflektivität verlieren. Um dem entgegenzuwirken, wird vorgeschlagen, während des Betriebes des EUV-Lithographiegerätes kontinuierlich den Kontaminationsgrad festzustellen, z.B. mittels Quarzkristallmikrowaagen. In Abhängigkeit vom Kontaminationsgrad wird dem Inneren des Lithographiegerätes Sauerstoff zugeführt. Der Sauerstoff in Verbindung mit der Belichtungsstrahlung baut die Kontamination während des Betriebes des Lithographiegerätes wieder ab. Das EUV-Lithographiegerät ist dazu mit mindestens einer Messeinrichtung (3) und einer damit verbundenen Kontroll- und Steuereinrichung (4) ausgerüstet, die ihrerseits mit einer Sauerstoffzufuhr (5a) verbunden ist.

## Beschreibung

Die Erfindung betrifft ein Verfahren sowie eine Vorrichtung zur In-situ-Dekontamination eines EUV-Lithographiegerätes.

EUV-Lithographiegeräte werden bei der Herstellung von Halbleiterbauelementen, wie z.B. integrierten Schaltkreisen verwendet. Lithographiegeräte, die im extrem ultravioletten Wellenlängenbereich betrieben werden (z.B. bei einer Wellenlänge von 13,4 nm), weisen als optische Elemente überwiegend Viellagensysteme aus beispielsweise Molybdän und Silizium auf. EUV-Lithographiegeräte weisen zwar in ihrem Inneren ein Vakuum oder eine Inertgasatmosphäre auf, es läßt sich aber nicht völlig verhindern, daß sich auch Kohlenwasserstoffe und/oder sonstige Kohlenstoffverbindungen innerhalb des Gerätes befinden. Diese Kohlenstoffverbindungen werden durch die extreme ultraviolette Strahlung aufgespalten, was dazu führt, daß sich ein kohlenstoffhaltiger Kontaminationsfilm auf den optischen Elementen niederschlägt. Diese Kontamination mit Kohlenstoffverbindung führt zu signifikanten Reflektionsverlusten der optischen Funktionsflächen, was einen erheblichen Einfluß auf die Wirtschaftlichkeit der EUV-Lithographieverfahren haben kann.

Das Problem der Kontamination ist nicht nur bei Lithographiegeräten von großer Bedeutung.

In der WO 87/02603 wird ein Verfahren beschrieben, mit dem Satelliten, Raumfähren, Raketen und Sonden während des Fluges gereinigt werden, indem ein Sauerstoffstrahl bzw. ein Sauerstoffionenstrahl auf die zu reinigenden Außenflächen gerichtet wird. Die UV-Strahlung der Sonne wird zur Bildung von zusätzlichem Ozon augsgenutzt. Sowohl der Sauerstoff als auch das Ozon reagieren mit den Kohlenstoffkontaminationen zu flüchtigen Verbindungen. Zum Steuern des Reinigungsprozesses, d.h. zum Feststellen, wann der Reinigungsprozeß begonnen und beendet werden soll, kann ein Sensor vorgesehen sein.

Gemäß der US 5,024,968 werden Substrate, insbesondere Siliziumsubstrate mit UV-Lasern einer Wellenlänge zwischen 200 und 300 nm von kontaminierenden Kohlenstoffverbindungen gesäubert. Die Lasereinstellung wird dabei über die Ergebnisse von Restgasanalysen gesteuert. Als Maßnahme gegen erneute Kontamination wird das Substrat mit Inertgas umspült.

Auch in der EP 0 660 188 B1 wird ein Linsensystem als Maßnahme gegen die Bildung von Kontamination mit Inertgasen und etwas extern hergestelltem Ozon umspült.

In der Publikation von E.D. Johnson et al., NIM A266 (1988) 381 wird erläutert, daß Röntgenmonochromatoren in situ über Glühentladungen gereinigt werden. Dazu ist ein Glühentladungsreaktor mit Zuführungen für Sauerstoff und Wasser direkt an die Monochromatorbox gekoppelt. Der Reinigungsprozeß dauert ca. 24 Stunden. Der Endpunkt des Säuberungsprozesses kann z.B. über Restgasanalysen oder spektrophotometrische Messungen ermittelt werden. Eine umständlichere Methode zur Bestimmung des Kontaminationsgrades besteht darin, von Zeit zu Zeit die Monochromatorbox abzupumpen und die Reflektivität des Monochromators zu messen.

Gemäß der JP H11-329931 A wird während der Durchführung von Elektronenstrahllithographie der elektrische Widerstand auf der Maske gemessen, um zu entscheiden, ob die Maske von Kontamination gereinigt werden muß oder nicht. An dem Lithographiegerät sind mehrere Masken vorhanden, so daß, sobald eine Maske gereinigt werden muß, sie durch eine saubere Maske aus dem Vorrat ersetzt werden kann. Die zu säubernde Maske wird aus dem Strahlengang entfernt und in einer Nebenkammer durch Bestrahlung mit ultraviolettem Licht und Spülen mit Sauerstoff gereinigt.

In der EP 0 421 745 B1 wird eine Vorrichtung zur Dekontamination von optischen Elementen beschrieben. Dazu sind neben einer Reaktionskammer zur Aufnahme des zu reinigenden optischen Elements Gaszuführeinrichtungen sowie Auswahleinrichtungen zum Auswählen von Strahlung eines erwünschten Wellenlängenbereiches vorgesehen. Konkret werden Sauerstoff und UV-Strahlung verwendet, um die hauptsächlich auf Kohlenstoffverbindungen basierende Kontamination photochemisch zu ätzen.

In der EP 0 874 283 A2 wird eine Lithographievorrichtung beschrieben. Über Transmissionsmessungen wird der Kontaminationsgrad innerhalb der Vorrichtung bestimmt und beim Überschreiten eines Schwellenwertes ein In-situ-Säuberungsvorgang eingeleitet. Zum Säubern wird das zum Belichten verwendete UV-Licht (ArF-Laser, 193 nm) eingesetzt. Zu diesem Zweck wird der Belichtungsvorgang unterbrochen und in den Strahlengang ein optisches Element, wie z.B. ein Prisma eingebracht, das den Strahlengang derart verändert, daß möglichst viele Stellen innerhalb der Lithographievorrichtung ausgeleuchtet werden. Innerhalb der Lithographievorrichtung herrscht eine Stickstoffatmosphäre. Zur Unterstützung des Reinigungseffektes können dem Stickstoff Sauerstoff, Ozon oder Sauerstoffradikale beigemischt werden. Auch während des Säuberns wird über Transmissionsmessungen kontinuierlich der Kontaminationsgrad festgestellt und beim Unterschreiten des Schwellenwertes der Säuberungsprozeß beendet.

Vor diesem Hintergrund ist es Aufgabe der vorliegenden Erfindung, ein Verfahren bzw. eine Vorrichtung zur Dekontamination eines EUV-Lithographiegerätes bereitzustellen, bei dem Stillstandzeiten vermieden werden und apparative Veränderungen an dem zu reinigenden EUV-Lithographiegerät gering gehalten werden.

Diese Aufgabe wird gelöst durch ein Verfahren gemäß Anspruch 1 sowie durch eine Vorrichtung gemäß Anspruch 9.

Überraschenderweise wurde nämlich festgestellt, daß bei gezielter Zufuhr von Sauerstoff in das Lithographiegerät die zum Belichten eingesetzte Strahlung in ihrem Belichtungstrahlengang bereits ausreicht, das Gerätinnere von Kontamination zu reinigen, falls kontinuierlich der Kontaminationsgrad festgestellt wird und mit vorgegebenen Schwellenwerten verglichen wird. In Abhängigkeit vom aktuellen Kontaminationsgrad wird die Sauerstoffzufuhr zum Lithographiegerät angepaßt. Der zugeführte Sauerstoff wird im Belichtungsstrahlengang aktiviert, verteilt sich durch Diffusion und leichte Konvektion im gesamten Inneren des Lithographiegerätes und reagiert mit den Kontaminationsfilmen.

Durch die kontinuierliche Überwachung des Kontaminationsgrades wird gewährleistet, daß der Reinigungsprozeß schon eingeleitet wird, wenn die Kontaminationen so gering sind, daß sie den normalen Belichtungsbetrieb noch nicht beeinträchtigen. Da außerdem durch die kontinuierliche Kontaminationsgradüberwachung schon geringe Änderungen des Kontaminationsgrades detektiert werden, kann auch die Sauerstoffzufuhr dahingehend angepaßt werden, daß schon sehr geringe Sauerstoffpartialdrücke genügen, um das EUV-Lithographiegerät zu dekontaminieren, was den Vorteil hat, daß auch der Sauerstoff in derart geringen Mengen im Lithographiegerät vorhanden ist, daß der Belichtungsbetrieb nicht negativ beeinflußt wird.

Durch die Belichtungsstrahlung im extrem ultravioletten Wellenlängenbereich, insbesondere bei 13,4 nm, werden die zugeführten Sauerstoffmoleküle O₂ in hochreaktive Sauerstoffatome gespalten, die wiederum den Kontaminationsfilm auf Kohlenstoffverbindungsbasis auf den optischen Elementen oxidativ abbauen. Bei zu starkem Sauerstoffangebot könnte es im Anschluß an die Reinigung zu einem oxidativen Angriff der Siliziumschicht des Molybdän-Silizium-Viellagensystems kommen. Es würde sich in diesem Fall eine Quarzschicht (SiO₂) auf der Oberfläche ausbilden, die wie auch die Kontamination zu einem Reflektionsverlust führen würde. Durch das erfindungsgemäße Verfahren aber werden auch derartige Oberflächenbeeinträchtigungen verhindert. Denn mit Hilfe des erfindungsgemäßen Verfahrens wird genau so viel Sauerstoff zugeführt, daß der gesamte kohlenstoffhaltige Kontaminationsfilm und nur der kohlenstoffhaltige Kontaminationsfilm entfernt wird.

Die erfindungsgemäße Vorrichtung zur Dekontamination optischer Elemente eines EUV-Lithographiegerätes weist mindestens eine Meßeinrichtung zur Messung des Kontaminationsgrades der oder der optischen Elemente/Elementes sowie eine damit verbundene Kontroll- und Steuereinrichtung auf, die ihrerseits mit einer Einrichtung zur O₂-Zufuhr verbunden ist, und die zum Vergleich der gemessenen Kontaminationsgrade mit mindestens einem vorgegebenen Schwellenwert und zum Steuern der Sauerstoffzufuhr in Abhängigkeit von dem jeweiligen Vergleichsergebnis ausgebildet ist. Vorzugsweise liefert die Meßeinrichtung kontinuierlich Meßwerte des Kontaminationsgrades.

Als Kontroll- und Steuereinrichtung wird man vorzugsweise einen Rechner einsetzen. Der Rechner kann beispielsweise mit einem Dosierventil für die Sauerstoffzufuhr verbunden sein, das rechnergesteuert geöffnet und geschlossen wird, so daß Sauerstoff mit bestimmtem Druck und Fluß in das Vakuum des EUV-Lithographiegerätes dosiert wird. Die Flußmessung kann beispielsweise über einen Durchflußmesser, die Partialdruckmessung beispielsweise über Vakuummeßröhren (Bayard-Alpert Typ, kapazitive Messung etc.) oder ein Restgasmassenspektrometer erfolgen. Der eventuell überschüssige Sauerstoff sowie die Reaktionsprodukte werden von der oder den ohnehin am Lithographiegerät vorhandenen Pumpen evakuiert.

Um die Dekontamination zu beschleunigen hat es sich als vorteilhaft erwiesen, in Rahmen der Dekontaminationsvorrichtung mindestens eine Lichtquelle für Strahlung einer Wellenlänge zwischen 150 nm und 300 nm vorzusehen. Insbesondere bei einer Wellenlänge von 185 nm oder 254 nm wird nämlich aus dem zugeführten Sauerstoff hochreaktives Ozon gebildet. Erfindungsgemäß ist auch diese mindestens eine Lichtquelle an die Kontroll- und Steuereinrichtung gekoppelt und wird die Dosierung der UV-Strahlung gleichzeitig mit der O₂-Zufuhr geregelt.

Vorteilhafterweise wird der Kontaminationsgrad mit Hilfe von einem oder mehr Oszillatoren gemessen, die auf eine Änderung der Massenbelegung auf ihrer Oberfläche durch Änderung ihrer Resonanzfrequenz reagieren. In einer bevorzugten Ausführungsform weist die mindestens eine Meßeinrichtung dazu mindestens eine innerhalb des Lithographiegerätes anzuordnende Quarzkristallmikrowaage auf. Mit Quarzkristallmikrowaagen können kleinste Mengen an Kontamination auf einem beschichteten Schwingquarz detektiert werden.

Die Nachweisempfindlichkeit von Quarzkristallmikrowaagen liegt im Bereich von Mono- bis Submonolagen. Entscheidend ist die richtige Wahl der Fundamentalfrequenz der Schwingquarze. Je höher diese Frequenz ist, desto empfindlicher reagiert der Schwingquarz auf Massenänderungen an seiner Oberfläche. Der Kontaminationsfilm auf dem Schwingquarz äußert sich in einer Verstimmung der Grundfrequenz des Schwingquarzes. Die Frequenzänderung des Schwingquarzes ist auf die Massenänderungen aufgrund des abgeschiedenen Kontaminationsfilms zurückzuführen. Die Frequenzänderung steht in linearem Zusammenhang mit der Massenänderung.

In einer weiteren bevorzugten Ausführungsform weist die Dekontaminationsvorrichtung mindestens eine weitere Lichtquelle und mindestens einen Detektor auf, die innerhalb des Lithographiegerätes angeordnet sind. Der Kontaminationsgrad wird dann vorzugsweise über Reflektivitätsmessungen festgestellt. Gerade die Reflektivität von optischen Elementen ist sehr stark von etwaigen Kontaminationen abhängig. Außer der hohen Empfindlichkeit für etwaige Kontaminationen weist diese Meßmethode außerdem den Vorteil auf, daß mit der Reflektivitätsmessung die wichtigste Sollgröße des Lithographiegerätes festgestellt wird.

In einer ebenfalls bevorzugten Ausführungsform sind im Strahlengang der mindestens einen Lichtquelle in Lichtquellennähe ein Polarisator und in Detektornähe ein Analysator angeordnet. Auf diese Weise kann die Bildung der Kohlenstoffkontaminationsschicht bzw. deren Abbau bei oxidativer Reinigung ellipsometrisch verfolgt werden. In diesem Fall wird als Lichtquelle vorzugsweise ein Helium-Neonlaser gewählt. Dessen Licht wird von außen über einen entsprechenden Port bzw. Glasfenster in das EUV-Lithographiegerät eingestrahlt. Aus der Messung des p- und s-polarisierten reflektierten Laserlichts ist eine Überwachung der Kohlenstoffkontaminationsschichtdicke möglich.

Eine weitere bevorzugte Ausführungsform besteht darin, im Rahmen der Meßeinrichtung Mittel zur Messung eines Photostroms vorzusehen, die an optische Elemente im EUV-Lithographiegerät anzuschließen sind. Bei der Bildung einer kohlenstoffhaltigen Kontaminationsschicht auf den Molybdän-Silizium-Viellagensystemen in einem EUV-Lithographiegerät kommt es zu einer Veränderung des Photostroms, der bei Bestrahlung mit der Applikationswellenlänge im extrem ultravioletten Wellenlängenbereich, z.B. bei 13,4 nm gemessen werden kann. Die Veränderung des Photostroms läßt also einen direkten Rückschluß auf das Vorhandensein und die Dicke der Kontaminationsschicht zu.

Gemäß einer weiteren Ausführungsform ist eine Restgasmeßeinrichtung vorgesehen, die an die Kontroll- und Steuereinrichtung angeschlossen ist. Mittels der Restgasmeßeinrichtung wird der Kontaminationsgrad über Restgasmessungen ermittelt. Da durch die Sauerstoffzufuhr und das dadurch ausgelöste oxidative Reinigungsverfahren die Kohlenstoffkontaminationsschicht entfernt wird, wird vorzugsweise die Messung der Änderung der Partikeldrücke von CO und CO₂ durchgeführt. Sobald der Kohlenstoff oxidativ von der Oberfläche des optischen Elements abgereinigt ist, fallen die entsprechenden Partikeldrücke von CO und CO₂ wieder ab. Die Veränderung dieser Partikeldrücke kann als Maß für die oxidative Entfernung einer kohlenstoffhaltigen Kontaminationsschicht dienen.

Für die Dekontamination von EUV-Lithographiegeräten zur Verwendung in Herstellungsprozessen, bei denen die Anforderungen an die Wirtschaftlichkeit höher sind als an die Qualität, hat es sich als hinreichend erwiesen, bei den zuvor beschriebenen Kontaminationsmeßverfahren genau einen Schwellenwert des Kontaminationsgrades, wie z.B. der Dicke der Kontaminationsschicht, vorzugeben. Bei Überschreiten des Schwellenwertes wird Sauerstoff in einem Partialdruckbereich von 1 x 10 ⁻¹⁰ mbar bis 1 x 10⁻³ mbar zugeführt. Bei Unterschreitung des Schwellenwertes wird die Sauerstoffzufuhr wieder gestoppt. In diesem Fall kann die Kontroll- und Steuereinrichtung der Dekontaminationvorrichtung entsprechend schlicht z.B. als Diskriminator-Schaltung ausgebildet werden.

Im übrigen ist es zur Erhöhung der Güte und Effizienz des Verfahrens bzw. der Vorrichtung selbstverständlich möglich, mehrere Meßmethoden zur Feststellung des Kontaminationsgrades miteinander zu verbinden.

Die Erfindung soll anhand eines Ausführungsbeispieles näher erläutert werden. Dazu zeigt die
Figur eine schematische Skizze des Regelkreises zur Kontrolle des Dekontaminationsgrades bzw. Beseitigung der Kontamination.

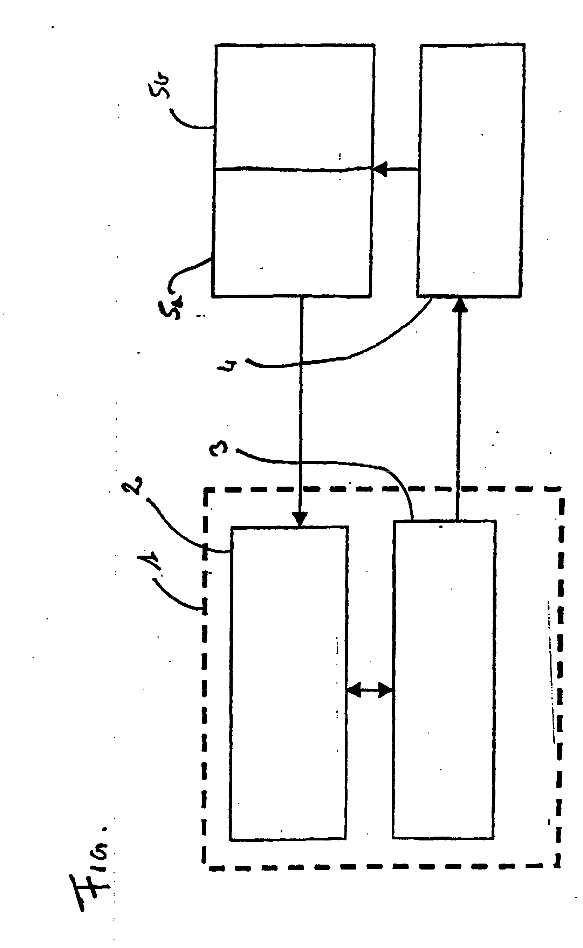

In der Figur ist ein Ausführungsbeispiel schematisch dargestellt, in dem durch die gestrichelte Linie der Vakuumrezipient 1 innerhalb des EUV-Lithographiegerätes bzw. bei größeren Anlagen der Vakuumrezipient 1, in dem das EUV-Lithographiegerät als Ganzes angeordnet ist, angedeutet ist. Innerhalb des Vakuumrezipienten 1 sind sowohl die optischen Elemente 2 als auch eine Quarzkristallmikrowaage 3 angeordnet. Bei den optischen Elementen 2 handelt es sich um Reflektoren mit Molybdän-Silizium-Viellagensystemen für eine Wellenlänge von 13,4 nm. Bei dieser Wellenlänge werden Silizium-Wafer mit Hilfe des Lithographiegerätes belichtet.

Um bei der Quarzkristallmikrowaage 3 die gleichen Bedingungen zu haben wie bei den optischen Elementen 2 innerhalb des EUV-Lithographiegerätes, ist auch der Schwingquarz der Quarzkristallmikrowaage 3 mit einer entsprechenden Molybdän-Silizium-Viellagenschicht versehen. Außerdem ist die Quarzkristallwaage 3 derart innerhalb des Vakuumrezipienten 1 angeordnet, daß der Schwingquarz EUV-Strahlung derselben Intensität bzw. Leistungsdichte wie die optischen Elemente 2 ausgesetzt ist.

Die Bildung eines Kontaminationsfilmes auf dem Schwingquarz 3 führt zu einer Verstimmung der Grundfrequenz des Schwingquarzes. Während des Betriebes des EUV-Lithographiegerätes mißt die Quarzmikrowaage 3 laufend die aufgrund der Bestrahlung abgeschiedene Kontaminationsmenge über die entsprechende Frequenzänderung, die der Masse abgeschiedener Kontamination proportional ist.

Über einen Rechner 4 wird die Frequenzänderung verarbeitet und mit der ursprünglichen Grundfrequenz des kontaminationsfreien Schwingquarzes samt Molybdän-Silizium-Viellagenbeschichtung verglichen. Sobald eine Frequenzabweichung aufgrund der Ausbildung einer kohlenstoffhaltigen Kontaminationsschicht vorliegt, wird über den Rechner 4 das Dosierventil der Sauerstoffzufuhr 5a geöffnet. Die Menge des über das Dosierventil zugeführten Sauerstoffs wird über Partialdruckmessung oder Flußmessungen kontrolliert. Bei Bedarf wird auch die Quecksilberniederdrucklampe 5b zur Erzeugung von UV-Strahlung dazugeschaltet. Der in den Vakuumrezipienten 1 eingeführte Sauerstoff baut den Kontaminationsfilm oxidativ ab. Falls zusätzlich über die Quecksilberniederdrucklampe 5b UV-Licht im Vakuumrezipienten 1 eingestrahlt wird, bildet sich zusätzliches Ozon, das ebenfalls den Kontaminationsfilm abbaut.

Während des gesamten Reinigungsprozesses wird kontinuierlich die Frequenz der Quarzkristallmikrowaage 3 gemessen und von dem Rechner 4 entschieden, ob die Sauerstoffzufuhr modifiziert werden muß und ob UV-Strahlung zusätzlich eingestrahlt werden sollte. Dazu können im Rechner 4 Parametersätze gespeichert sein, die beispielsweise Sauerstoffpartialdrücke und/oder UV-Strahlungsintensitäten in Abhängigkeit von gemessenen Frequenzen angeben. Bei der Durchführung der Kontaminationsgradkontrolle mit Hilfe einer Quarzkristallmikrowaage ist es notwendig, daß der Schwingquarz äußerst genau Temperatur-kontrolliert wird (besser als ± 1 K), um zuverlässige Frequenzmessungen zu erhalten.

In einer einfachen Variante kann auch nur die Grundfrequenz als Schwellenwert dienen: Falls die gemessene Frequenz ungleich der Grundfrequenz ist, wird Sauerstoff zugeführt; sobald die Grundfrequenz wieder erreicht ist, wird die Sauerstoffzufuhr unterbrochen.

Analog zu dem in der Figur dargestellten Ausführungsbeispiel können anstelle der Quarzkristallmikrowaage 3 auch Mittel zur Messung des Photostroms oder eine Lichtquelle und einen Detektor zur Messung der Reflektivität bzw. in Verbindung mit einem Polarisator und Analysator zur ellipsometrischen Bestimmung der Kontaminationschichtdicke vorgesehen sein. Weiterhin kann während der Sauerstoffzufuhr über Restgasanalysen festgestellt werden, wieviel Kontamination bereits abgebaut wurde, und auch diese Daten vom Rechner zur Kontaminationsgradkontrolle und Anpassung der Sauerstoffzufuhr verwendet werden.

Das oben stehende Beispiel wurde für nur eine Quarzkristallmikrowaage 3 beschrieben. Selbstverständlich können innerhalb des Vakuumrezipienten 1 an diversen Stellen Quarzkristallmikrowaagen oder andere Meßmittel vorgesehen sein, um den Kontaminationsgrad innerhalb des Vakuumrezipienten 1 genau feststellen zu können. Entsprechend kann eine Mehrzahl von Sauerstoffzuleitungen und Dosierventilen 5a vorgesehen sein, so daß je nach unterschiedlichem Kontaminationsgrad lokal unterschiedliche Sauerstoffpartialdrücke eingestellt werden können.

## Patentansprüche

1. Verfahren zur In-Situ-Dekontamination eines EUV-Lithographiegerätes mit den Schritten:
- Messen des aktuellen Kontaminationsgrades,
- Vergleichen des Kontaminationsgrades mit mindestens einem vorgegebenen Schwellenwert,
- Anpassen der O₂-Zufuhr zum Lithographiegerät,
- Wiederholen der vorstehenden Schritte,
wobei alle Schritte während des Belichtungsbetriebes durchgeführt werden.

2. Verfahren nach Anspruch 1, **dadurch gekennzeichnet, daß** zusätzlich zur Anpassung der O₂-Zufuhr UV-Strahlung einer Wellenlänge zwischen 150 nm und 300 nm in das EUV-Lithographiegerät eingestrahlt wird.

3. Verfahren nach Anspruch 1 oder 2, **dadurch gekennzeichnet, daß** der Kontaminationsgrad mit Hilfe von einem oder mehreren Oszillatoren, die auf Änderung der Massenbelegung auf ihrer Oberfläche durch Änderung der Resonanzfrequenz reagieren, gemessen wird.

4. Verfahren nach Anspruch 1 oder 2, **dadurch gekennzeichnet, daß** der Kontaminationsgrad über Reflektivitätsmessungen festgestellt wird.

5. Verfahren nach Anspruch 1 oder 2, **dadurch gekennzeichnet, daß** der Kontaminationsgrad ellipsometrisch festgestellt wird.

6. Verfahren nach Anspruch 1 oder 2, **dadurch gekennzeichnet, daß** der Kontaminationsgrad über die Messung eines Photostroms ermittelt wird.

7. Verfahren nach einem der Ansprüche 1 bis 6, **dadurch gekennzeichnet, daß** während der Sauerstoffzufuhr der Kontaminationsgrad über Restgasmessungen festgestellt wird.

8. Verfahren nach einem der Ansprüche 1 bis 7, **dadurch gekennzeichnet, daß** genau ein Schwellenwert vorgegeben ist, bei Überschreiten des Schwellenwertes Sauerstoff in einem Partialdruckbereich von 1x10⁻¹⁰ mbar bis 1x10⁻³ mbar zugeführt wird und bei Unterschreiten des Schwellenwertes die Sauerstoffzufuhr gestoppt wird.

9. Vorrichtung zur In-situ-Dekontamination optischer Elemente eines EUV-Lithographiegerätes, umfassend mindestens eine Meßeinrichtung (3) zur Messung des Kontaminationsgrades des oder der optischen Elementes/Elemente und eine damit verbundene Kontroll- und Steuereinrichtung (4), die ihrerseits mit einer Einrichtung zur O₂-Zufuhr (5a) zum EUV-Lithographiegerät verbunden ist und die zum Vergleichen der gemessenen Kontaminationsgrade mit mindestens einem vorgegebenen Schwellenwert und zum Steuern der Sauerstoffzufuhr in Abhängigkeit von dem jeweiligen Vergleichsergebnis ausgebildet ist.

10. Vorrichtung nach Anspruch 9, **dadurch gekennzeichnet, daß** die Vorrichtung mindestens eine Lichtquelle (5b) für Strahlung einer Wellenlänge zwischen 150 nm und 300 nm aufweist.

11. Vorrichtung nach Anspruch 9 oder 10, **dadurch gekennzeichnet, daß** die mindestens eine Meßeinrichtung (3) mindestens eine innerhalb des Lithographiegerätes anzuordnende Quarzkristallmikrowaage (3) aufweist.

12. Vorrichtung nach Anspruch 9 oder 10, **dadurch gekennzeichnet, daß** die Meßeinrichtung (3) mindestens eine weitere Lichtquelle und mindestens einen Detektor aufweist, die innerhalb des Lithographiegeräts anzuordnen sind.

13. Vorrichtung nach Anspruch 12, **dadurch gekennzeichnet, daß** im Strahlengang der mindestens einen Lichtquelle in Lichtquellennähe ein Polarisator und in Detektornähe ein Analysator angeordnet sind.

14. Vorrichtung nach Anspruch 9 oder 10, **dadurch gekennzeichnet, daß** die Meßeinrichtung (3) Mittel zur Messung eines Photostroms aufweist, die an optische Elemente (2) im EUV-Lithographiegerät anzuschließen sind.

15. Vorrichtung nach einem der Ansprüche 9 bis 14, **dadurch gekennzeichnet, daß** eine an die Kontroll- und Steuereinrichtung (4) angeschlossene Meßeinrichtung als Restgasmeßeinrichtung ausgebildet ist.
